# EUROPEAN PATENT APPLICATION

(11) **EP 2 045 919 A2**
(43) Date of publication of application: **08.04.2009**
(21) Application number: 08017217.4
(22) Date of filing: 30.09.2008
(51) Int. Cl.: H03K 5/156

(54) **Semiconductor circuit**

(30) Priority: 04.10.2007 JP 2007261203
(71) Applicant: NEC Electronics Corporation, Kawasaki, Kanagawa 211-8668 (JP)
(72) Inventor: Aoki, Yasushi, Kawasaki Kanagawa 211-8668 (JP)
(74) Representative: Glawe, Delfs, Moll

(57) **Abstract**

In a conventional circuit to buffer differential clock signals at plural stages, the deteriorations of duty ratios caused by the variations of transistors constituting the circuit have not been compensated. Further, when it is attempted to increase the effect of compensating the duty ratios, the size of the circuit increases and the consumed electric current also increases accordingly. A semiconductor circuit according to the present invention includes: a differential input section to receive input differential signals; differential signal output terminals to output output differential signals in accordance with the voltages input into the differential input section; a low-pass filter to extract the DC components of signals output from the differential signal output terminals; and a load resistor section connected to the differential input section, wherein resistance values are determined on the basis of the DC components of the signals extracted with the low-pass filter.

## Description

### FIELD OF THE INVENTION

The present invention relates to a semiconductor circuit and more particularly to a semiconductor circuit to compensate the deterioration of a duty ratio of an output differential signal.

### BACKGROUND OF THE INVENTION

In recent years, as a transmission system of high speed signals, attention is focused on CML (Current Mode Logic). A differential signal transmission system is used for the transmission of signals in CML. Further, a signal level of a small amplitude (hereunder refereed to as a CML level) is used in CML and a signal level of a large amplitude (hereunder referred to as a CMOS level) ranging from a supply voltage to a ground voltage) is used in an internal circuit in which signals are transmitted.

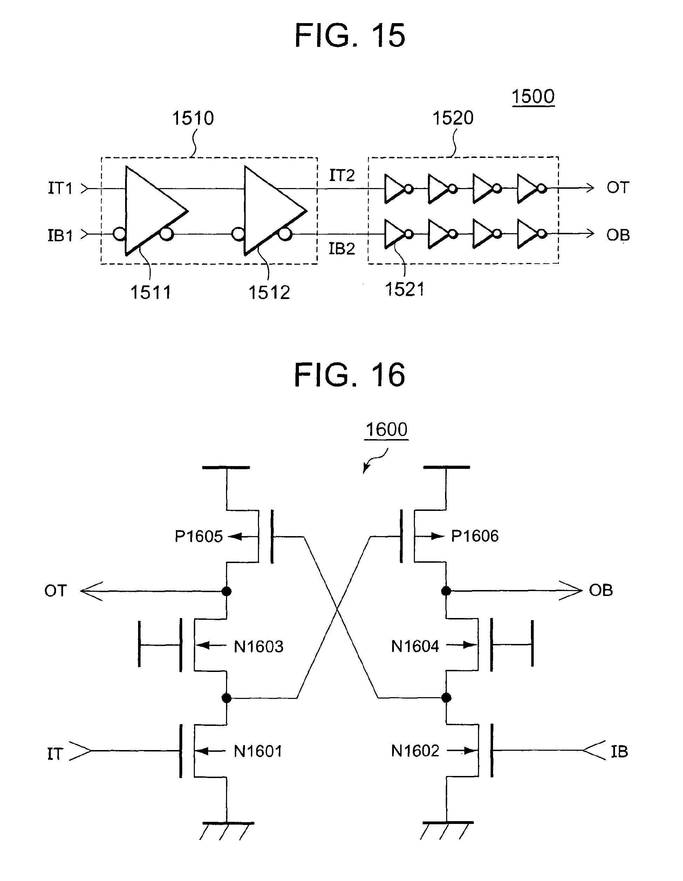

Here, FIG. 15 shows a schematic diagram of a circuit 1500 to input differential clock signals as small signals of the CML level, transform them into differential clock signals of a large amplitude such as CMOS level signals, and distribute them. As shown in FIG. 15, in the circuit 1500, firstly differential clock signals IT1 and IB1 as small signals of the CML level are amplified and transformed into differential clock signals IT2 and IB2 of a CMOS level with a differential buffering circuit 1510 composed of plural-stage differential amplifiers 1511 and 1512. Successively, the differential clock signals IT2 and IB2 are input into a multistage buffering circuit 1520 composed of CMOS inverters 1521 of plural stages and differential clock signals OT and OB are output.

As each of the differential amplifiers 1511 and 1512, a differential amplifier 1600 composed of transistors 1601 to 1606 as shown in FIG. 16, a differential amplifier 1700 formed by adding transistors 1607 to 1610 and a transfer gate 1611 to the differential amplifier 1600, or the like is used.

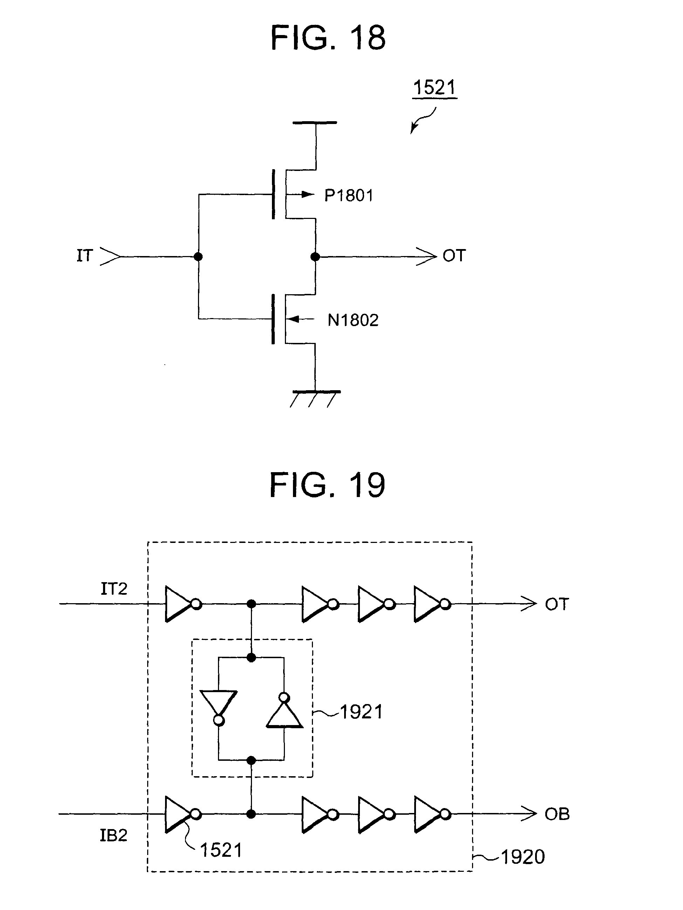

The multistage buffering circuit 1520 includes the CMOS inverters 1521 each of which is shown in FIG. 18. Such a multistage buffering circuit 1520 does not have the function of compensating the deteriorations of duty ratios when the duty ratios of the input differential clock signals IT2 and IB2 are deteriorated.

Meanwhile, a circuit having a circuit composed of cross-coupled CMOS inverters (hereunder referred to as a CMOS inverter cross-coupling circuit) in order to compensate the deteriorations of the duty ratios of input differential clock signals is disclosed in US Patent No. 5,621,340. In a circuit using a CMOS inverter cross-coupling circuit however, the deterioration of a duty ratio may be compensated in some cases and may not be compensated in other cases. Explanations are hereunder made on a case where the deterioration of a duty ratio may be compensated and a case where the deterioration of a duty ratio may not be compensated in a multistage buffering circuit 1920 using a CMOS inverter cross-coupling circuit.

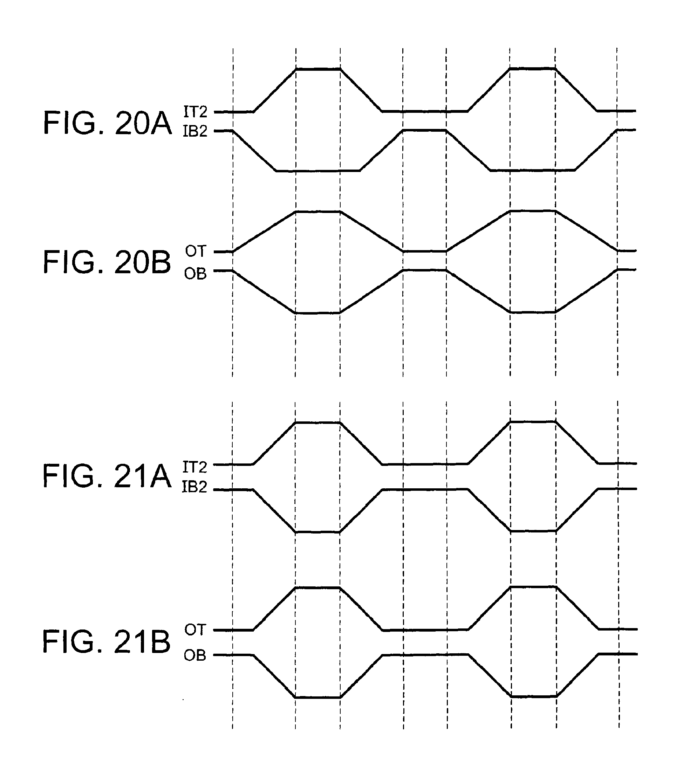

Here, such input differential clock signals IT2 and IB2 as shown in the time chart of FIG. 20Aare input into the multistage buffering circuit 1920. Both the input differential clock signals IT2 (positive phase) and IB2 (negative phase) show the deteriorations of the duty ratios of a short high level and a long low level. When such input differential clock signals IT2 and IB2 are input in the multistage buffering circuit 1920, the CMOS inverter cross-coupling circuit 1921 dulls the rising edges and the falling edges of the signal waveforms. Consequently, such output differential clock signals OT and OB as shown in FIG. 20B are output from the multistage buffering circuit 1920. In the output differential clock signals OT and OB, the deteriorations of the duty ratios are compensated as it is understood from FIG. 20B. When both the input differential clock signals IT2 (positive phase) and IB2 (negative phase) show the deteriorations of the duty ratios of a long high level and a short low level inversely with the above case, the multistage buffering circuit 1920 compensates the deteriorations of the duty ratios in the same way.

Successively, such input differential clock signals IT2 and IB2 as shown in the time chart of FIG. 21A are input into the multistage buffering circuit 1920. The input differential clock signals IT2 (positive phase) and IB2 (negative phase) show the deteriorations of the duty ratios wherein the high level of IT2 (positive phase) is short and the low level of IB2 (negative phase) is long. On this occasion, the multistage buffering circuit 1920 cannot compensate the deteriorations of the duty ratios of the input differential clock signals IT2 and IB2. The reason is that the difference between the clock signal IT2 and the clock signal IB2 is only that the phases are inversed and hence signals having phases inversed from the phases of the clock signal IT2 and the clock signal IB2 are output also to both the terminals of the CMOS inverter cross-coupling circuit 1921. Consequently, the differential clock signals OT and OB having deteriorated duty ratios as shown in FIG. 21B are output from the multistage buffering circuit 1920. Further, with regard to input differential clock signals IT2 and IB2 wherein the high level of IT2 (positive phase) is long and the low level of IB2 (negative phase) is short too, the deteriorations of the duty ratios cannot be compensated.

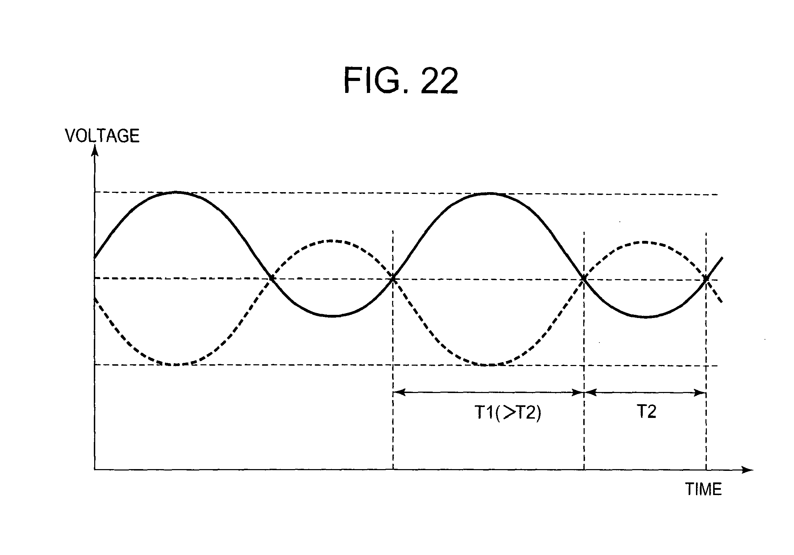

Here, the input differential clock signals input into the multistage buffering circuit 1920 are IT2 and IB2 that are the signals output from the aforementioned differential buffering circuit 1510. Here, if input differential clock signals IT1 and IB1 having deteriorated duty ratios are input into the differential buffering circuit 1510 or the differential buffering circuit 1510 has an input offset, such differential signals having deteriorated duty ratios as shown in FIG. 22 are output. Such differential signals having deteriorated duty ratios, when they are transformed into differential clock signals of a CMOS level, come to clock signals having deteriorated duty ratios wherein the high level of IT2 (positive phase) is short and low level of IB2 (negative phase) is long as shown in FIG. 21A. Consequently, when such signals are input in such a circuit as the multistage buffering circuit 1920, the problem is that the deteriorations of the duty ratios of output clock signals cannot be compensated.

Further, the deteriorations of the duty ratios in the multistage buffering circuit 1920 are compensated with the CMOS inverter cross-coupling circuit 1921 as stated above. Consequently, the deteriorations of duty ratios occurring in a circuit after a node to which the CMOS inverter cross-coupling circuit 1921 is connected are not compensated. Consequently, the effect of compensating the deteriorations of duty ratios is obtained when the CMOS inverter cross-coupling circuit 1921 is connected to a stage subsequent to the multistage buffering circuit. However, since the size of a circuit subsequent to the multistage buffering circuit is large, the circuit size of the CMOS inverter cross-coupling circuit 1921 connected to the subsequent stage is also large. Then an accompanying problem is that the consumed electric current of the circuit also increases.

Further, the duty ratios of output differential clock signals OT and OB caused by relative variations of transistors constituting the multistage buffering circuit 1920 also deteriorate. However, the deteriorations of the duty ratios in this case cannot be compensated with the multistage buffering circuit 1920.

Meanwhile, JP-A No. Hei11(1999)-274902 discloses a technology of compensating duty ratios by connecting a low-pass filter to the differential output of a differential receiver, amplifying the difference in the outputs of the low-pass filter, and feeding back the difference to an input of the differential receiver. A problem of the technology however is that, when elements such as transistors constituting a differential amplifier for compensation have variations, an input offset cannot be compensated and the duty ratios of the output differential signals are deteriorated.

### SUMMARY

A multistage buffering circuit according to a conventional technology cannot compensate the deteriorations of duty ratios caused by the variations of transistors constituting the circuit or, for example, the deteriorations of duty ratios of merely inversed input differential clock signals or the like as shown in FIG. 21A.

A semiconductor circuit according to the present invention includes: a differential input section to receive input differential signals; differential signal output terminals to output output differential signals in accordance with the voltages input into the differential input section; a low-pass filter to extract the DC components of signals output from the differential signal output terminals; anda loadresistor section connected to the differential input section wherein resistance values are determined on the basis of the DC components of the signals extracted with the low-pass filter.

In the semiconductor circuit according to the present invention, DC voltage components of signals that are extracted with the low-pass filter, are output from the differential signal output terminals, and have the deteriorations of duty ratios are fed back to the load resistor section connected to the differential input section to receive input differential signals. The feed back loop is configured so that the resistance values of the load resistor section may be determined by the fed-back DC voltage components. As a result, the deteriorations of duty ratios in the differential signals output from the differential signal output terminals are compensated with the circuit constituting the feed back loop.

The present invention makes it possible to compensate with a simple circuit structure: the deteriorations of duty ratios caused by the variations of transistors constituting the circuit; and the deteriorations of the duty ratios of merely inversed input differential clock signals that have not been compensated in a conventional multistage buffering circuit.

### BRIEF DESCRIPTION OF THE DRAWINGS

FIG. 1 is a diagram showing the structure of a multistage buffering circuit according to the first embodiment;
FIGS. 2A, 2B, 2C, and 2D are charts showing the waveforms in the operations of a multistage buffering circuit according to the first embodiment;
FIG. 3 is a diagram showing the structure of another multistage buffering circuit according to the first embodiment.
FIGS. 4A, 4B, 4C and 4D are charts showing the waveforms in the operations of another multistage buffering circuit according to the first embodiment;
FIG. 5 is a diagram showing the circuit structure of another low-pass filter in a multistage buffering circuit according to the first embodiment;
FIG. 6 is a diagram showing the circuit structure of yet another low-pass filter in a multistage buffering circuit according to the first embodiment;
FIG. 7 is a diagram showing the circuit structure of still another low-pass filter in a multistage buffering circuit according to the first embodiment;
FIG. 8 is a diagram showing another structure of the connection between a CMOS inverter of the first stage and a load resistor section in a multistage buffering circuit according to the first embodiment;
FIG. 9 is a diagram showing yet another structure of the connection between a CMOS inverter of the first stage and a load resistor section in a multistage buffering circuit according to the first embodiment;
FIG. 10 is a diagram showing still another structure of the connection between a CMOS inverter of the first stage and a load resistor section in a multistage buffering circuit according to the first embodiment;
FIG. 11 is a diagram showing yet another structure of the connection between a CMOS inverter of the first stage and a load resistor section in a multistage buffering circuit according to the first embodiment;
FIG. 12 is a diagram showing still another structure of the connection between a CMOS inverter of the first stage and a load resistor section in a multistage buffering circuit according to the first embodiment;
FIG. 13 is a diagram showing yet another structure of the connection between a CMOS inverter of the first stage and a load resistor section in a multistage buffering circuit according to the first embodiment;
FIG. 14 is a diagram showing still another structure of the connection between a CMOS inverter of the first stage and a load resistor section in a multistage buffering circuit according to the first embodiment;
FIG. 15 is a diagram showing a general circuit structure of a semiconductor circuit according to a conventional technology;
FIG. 16 is a diagram showing a circuit structure of a differential amplifier in a semiconductor circuit according to a conventional technology;

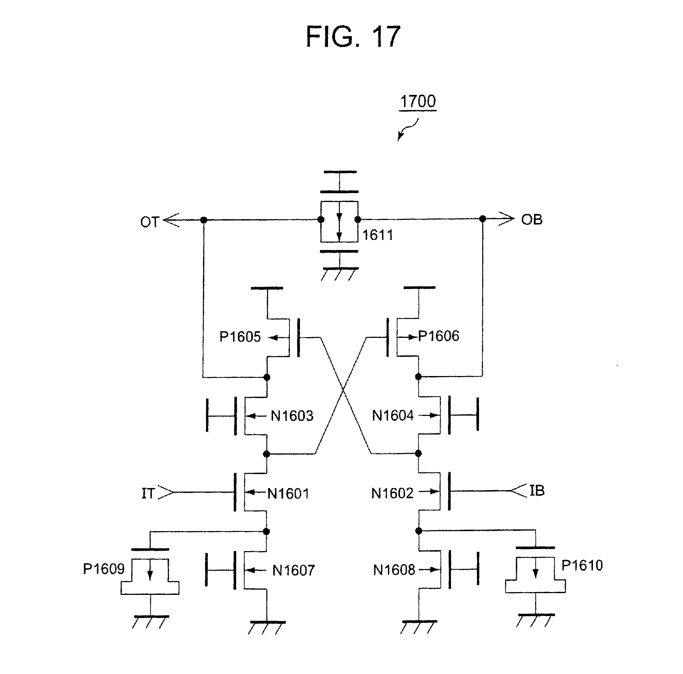

FIG. 17 is a diagram showing a circuit structure of another differential amplifier in a semiconductor circuit according to a conventional technology;
FIG. 18 is a diagram showing the structure of an ordinary CMOS inverter;
FIG. 19 is a diagram showing a general structure of a multistage buffering circuit according to a conventional technology;
FIGS. 20A and 20B are charts showing I/O differential clock signals of a multistage buffering circuit according to a conventional technology;
FIGS. 21A and 21B are charts showing I/O differential clock signals of a multistage buffering circuit according to a conventional technology; and
FIG. 22 is a chart showing differential signals output from a differential amplifier in a semiconductor circuit according to a conventional technology.

### DETAILED DESCRIPTION OF THE PREFERRED EMBODIMENTS

### First Embodiment

The first embodiment according to the present invention is hereunder explained in detail in reference to drawings. In the first embodiment, the present invention is applied to a multistage buffering circuit 100.

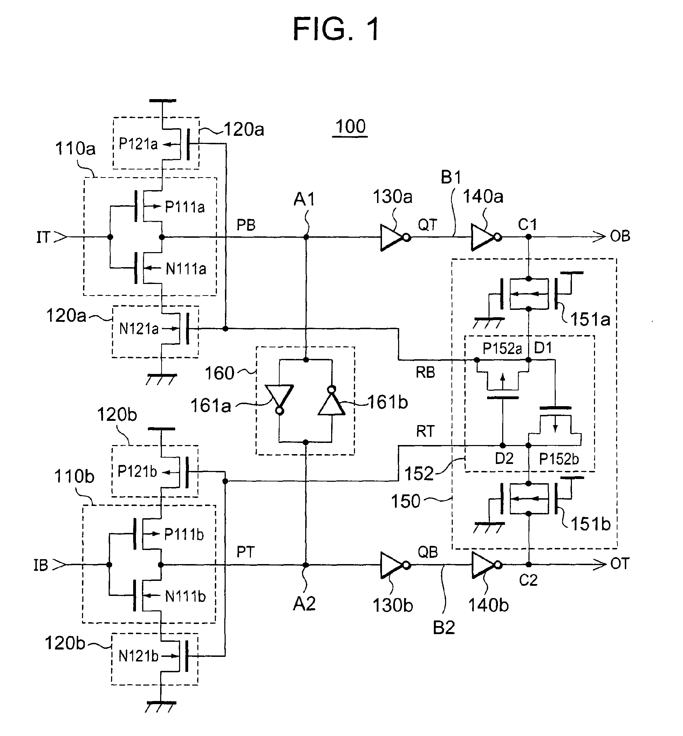

An example of the circuit structure of a multistage buffering circuit 100 according to the first embodiment is shown in FIG. 1. Themultistage buffering circuit 100 has CMOS inverter circuits 110a and 110b, load resistors 120a and 120b, CMOS inverter circuits 130a and 130b, CMOS inverter circuits 140a and 140b, a low-pass filter 150, and a CMOS inverter cross-coupling circuit 160.

The CMOS inverter circuits 110a and 110b: receive and buffer input differential signals IT and IB; and then output differential signals PB and PT.

The CMOS inverter circuit 110a has a PMOS transistor P111a as a load transistor and an NMOS transistor N111a as a drive transistor. The signal IT (hereunder referred to as IT) that is one of the input differential signals IT and IB is input to both the gates of the PMOS transistor P111a and the NMOS transistor N111a. Further, the drain of the PMOS transistor P111a and the drain of the NMOS transistor N111a are connected to each other at a node A1. Thereby the CMOS inverter circuit 110a buffers the signal IT and outputs the signal PB (hereunder referred to as PB) that is one of the inverted differential signals PT and PB to the node A1.

Likewise, the CMOS inverter circuit 110b has a PMOS transistor P111b as a load transistor and an NMOS transistor N111b as a drive transistor. The signal IB (hereunder referred to as IB) that is the other of the input differential signals IT and IB is input to both the gates of the PMOS transistor P111b and the NMOS transistor N111b. Further, the drain of the PMOS transistor P111b and the drain of the NMOS transistor N111b are connected to each other at a node A2. Thereby the CMOS inverter circuit 110b buffers the signal IB and outputs the signal PT (hereunder referred to as PT) that is the other of the inverted differential signals PT and PB to the node A2.

Here, the CMOS inverter circuits 110a and 110b function as a differential input section referred to in the present invention. Further, the nodes A1 and A2 function as differential output terminals referred to in the present invention.

The load resistors 120a and 120b are connected to the CMOS inverter circuits 110a and 110b in series, respectively. The load resistor 120a has a PMOS transistor P121a and an NMOS transistor N121a. The signal RB (hereunder referred to as RB) that is one of the DC signals RT and RB output from the low-pass filter 150 is input to both the gates of the PMOS transistor P121a and the NMOS transistor N121a. Further, the source of the PMOS transistor P121a is connected to a supply voltage terminal and the drain thereof is connected to the source of the PMOS transistor P111a. The drain of the NMOS transistor N121a is connected to the source of the NMOS transistor N111a and the source thereof is connected to a ground terminal.

The load resistor 120b has a PMOS transistor P121b and an NMOS transistor N121b. The signal RT (hereunder referred to as RT) that is the other of the DC signals RT and RB output from the low-pass filter 150 is input to both the gates of the PMOS transistor P121b and the NMOS transistor N121b. Further, the source of the PMOS transistor P121b is connected to a supply voltage terminal and the drain thereof is connected to the source of the PMOS transistor P111b. The drain of the NMOS transistor N121b is connected to the source of the NMOS transistor N111b and the source thereof is connected to a ground terminal.

The CMOS inverter circuits 130a and 130b buffer and invert the differential signals PB and PT and output them to nodes B1 and B2 as differential signals QT and QB, respectively.

The CMOS inverter circuits 140a and 140b buffer and invert the differential signals QT and QB and output them to nodes C1 and C2 as differential signals OB and OT, respectively. Here, the differential signals OB and OT are the final output differential signals of the multistage buffering circuit 100.

The low-pass filter 150 receives the differential signals OB and OT and outputs the voltage signals RB and RT that are the DC components of the respective signals to the load resistors 120a and 120b. The low-pass filter 150 has transfer gates 151a and 151b and PMOS transistors P152a and P152b constituting a gate capacitor section 152. The combination of the transfer gates 151a and 151b constitutes a resistor section referred to in the present invention and the gate capacitor section 152 is a capacitor section referred to in the present invention. The transfer gates 151a and 151b are connected to the nodes C1 and D1 and the nodes C2 and D2, respectively. In the PMOS transistor P152a constituting the gate capacitor section 152, the gate is connected to the node D2 and the source and the drain are connected to the node D1. Likewise, in the PMOS transistor P152b constituting the gate capacitor section 152, the gate is connected to the node D1 and the source and the drain are connected to the node D2.

Here, the transfer gates 151a and 151b are used as resistive elements of the low-pass filter 150. In the PMOS transistors P152a and P152b, the gate capacitors of the transistors are used as capacitative elements of the low-pass filter 150. That is, an RC low-pass filter is formed with the resistances of the transfer gates 151a and 151b and the gate capacitors of the PMOS transistors P152a and P152b. By so doing, the low-pass filter 150 can output the voltages of DC components extracted from the differential signals OB and OT that are the final output of the multistage buffering circuit 100 as signals RB and RT.

The CMOS inverter cross-coupling circuit 160 has CMOS inverters 161a and 161b. The input of the CMOS inverter 161a and the output of the CMOS inverter 161b are connected to the node A1. Likewise, the output of the CMOS inverter 161a and the input of the CMOS inverter 161b are connected to the node A2. The CMOS inverter cross-coupling circuit 160 dulls the rising edges and the falling edges of the waveforms of the differential signals PB and PT applied to the nodes A1 and A2.

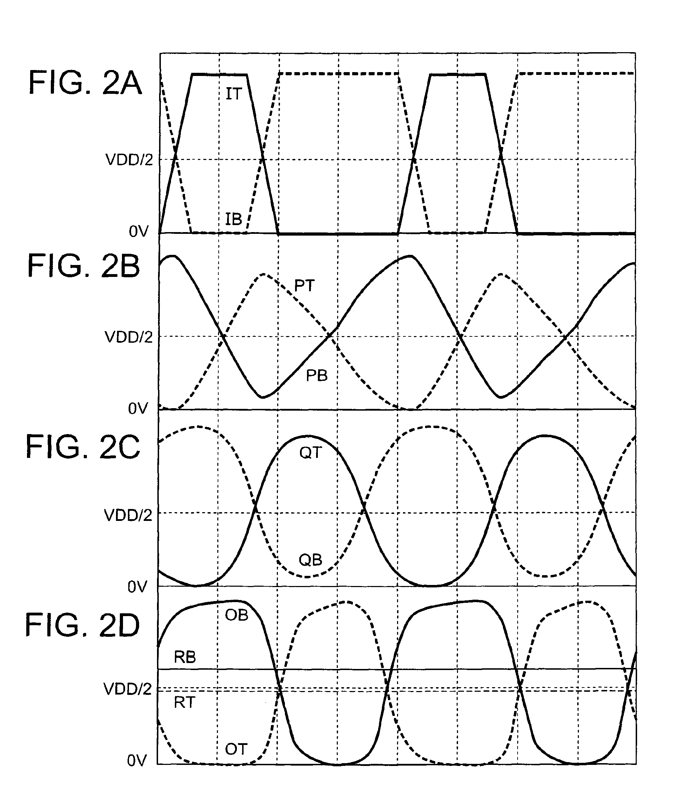

Operations are hereunder explained on the basis of the waveform charts, shown in FIG. 2, of a multistage buffering circuit 100 shown in FIG. 1. The input differential signals IT and IB of a CMOS level shown in the figure are differential clock signals wherein the high level of IT (positive phase) is short and the low level of IB (negative phase) is long as shown in FIG. 21A of a conventional technology.

Firstly, the input differential signals IT and IB are input respectively into the CMOS inverters 110a and 110b that are the first-stage buffering circuits in the multistage buffering circuit 100. The input differential signals IT and IB are buffered in the CMOS inverters 110a and 110b and inverted into differential signals PB and PT, respectively. The rising edges and the falling edges of the waveforms of the differential signals PB and PT are dulled with the CMOS inverter cross-coupling circuit 160. Successively, the differential signals PB and PT are input into the CMOS inverters 130a and 130b that are the second-stage buffering circuits, respectively. The differential signals PB and PT are buffered in the CMOS inverters 130a and 130b and inverted into the differential signals QT and QB, respectively. Further, the differential signals QT and QB are input into the CMOS inverters 140a and 140b that are the third-stage buffering circuits, respectively. The differential signals QT and QB are buffered in the CMOS inverters 140a and 140b and inverted into the output differential signals OB and OT, respectively. The output differential signals OB and OT are the differential clock signals finally output from the multistage buffering circuit 100.

Further, the output differential signals OB and OT are smoothed with the low-pass filter 150, immediately the DC voltage components are extracted, and the components are output as signals RB and RT of DC voltage, respectively. Here, if the deteriorations of duty ratios exist in the output differential signals OB and OT, the potentials of the signals RB and RT in the form of DC voltage rise or lower in accordance with the magnitude of the deteriorations of the duty ratios.

For example, the input differential signals IT and IB shown in FIG. 2 are differential clock signals wherein the high level of IT (positive phase) is short and the low level of IB (negative phase) is long as stated above and the duty ratios are deteriorated. Consequently, the output differential signals OB and OT that are finally output from the multistage buffering circuit 100 are also signals having deteriorated duty ratios. As a result, as shown in FIG. 2, the signal RB produced by smoothening the signal OB that is the output from the low-pass filter 150, namely by extracting the DC voltage component thereof, is output at a higher potential than the signal RT produced by smoothening the signal OT, namely by extracting the DC voltage component thereof.

The signals RB and RT are fed back to the load resistors 120a and 120b connected to the CMOS inverters 110a and 110b that are the first-stage buffering circuits, respectively. Then with the signals RB and RT, the load resistors 120a and 120b adjust the offsets of the inputs in the differential input sections 110a and 110b, respectively. By the adjustment, the offset of the input of the signal IT reduces, the potential of the signal PB output from the CMOS inverter 110a lowers, the offset of the input of the signal IB increases, and the potential of the signal PT output from the CMOS inverter 110b rises. That means that the vertical amplitudes of the differential signals PB and PT that are the respective output signals of the CMOS inverters 110a and 110b are controlled and the deteriorations of the duty ratios are compensated. As a result, the deteriorations of the duty ratios in the differential signals QT and QB that are the respective outputs of the CMOS inverters 130a and 130b as the second-stage buffering circuits are also compensated. Likewise, the deteriorations of the duty ratios i the differential signals OB and OT that are the respective outputs of the CMOS inverters 140a and 140b as the third-stage buffering circuits are also compensated.

The effect of the compensation is obtained from the fact that the multistage buffering circuit 100 is structured so as to feed back the signals RB and RT corresponding to the respective output differential signals OB and OT that are the final outputs of the multistage buffering circuit 100 to the first-stage CMOS inverters 110a and 110b, respectively. As a result, the multistage buffering circuit 100 effectively improves not only the deteriorations of the duty ratios in the input differential signals IT and IB but also the deteriorations of the duty ratios caused by the relative variations of the transistors constituting the CMOS inverters 130a and 130b and the CMOS inverters 140a and 140b.

For example, let's discuss the case where input differential signals IT and IB that have no deteriorations of the duty ratios are input but the duty ratios in the output differential signals OB and OT are deteriorated due to the relative variations of transistors constituting the CMOS inverters 110a and 110b to 140a and 140b. On this occasion, the signals RB and RT extracted from the output differential signals OB and OT with the low-pass filter 150 rise or lower in accordance with offsets caused by the CMOS inverters 110a and 110b to 140a and 140b. Consequently, the signals RB and RT fed back respectively to the CMOS inverters 110a and 110b control the load resistors 120a and 120b respectively so as to reduce the offsets.

From the above results, whereas a conventional technology has no compensation effect when differential clock signals having deteriorated duty ratios wherein the high level of IT (positive phase) is short and the low level of IB (negative phase) is long as shown in FIG. 21A (or the inverse thereof) are input, the multistage buffering circuit 100 has the effect of compensating the deteriorations of duty ratios in output signals. Further, whereas a conventional technology has no effect of compensating the deteriorations of duty ratios caused by the relative variations of transistors constituting circuits, the multistage buffering circuit 100 has the effect of compensating the deteriorations of duty ratios in output signals.

Further, the circuits added in the present invention are only a low-pass filter 150 and load resistors 120a and 120b and thus the increase of the circuit size is small. Furthermore, an additional advantage thereof is that the increase of electric power consumption caused by the addition of the low-pass filter 150 and the load resistors 120a and 120b is almost negligibly small.

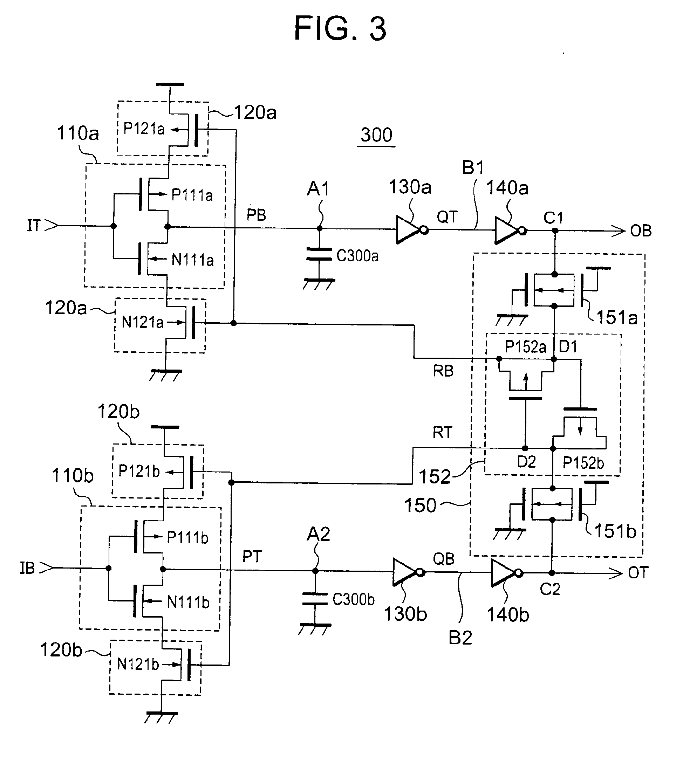

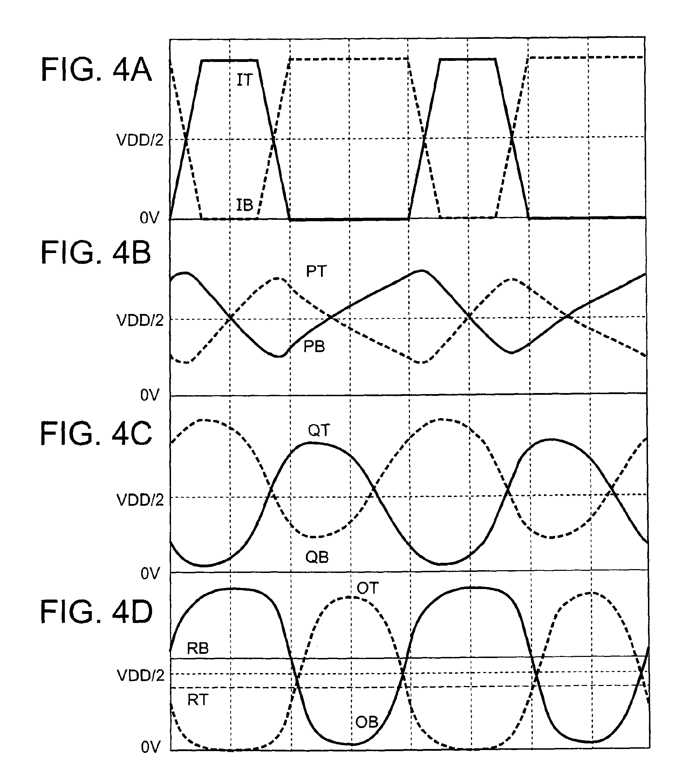

Here, the effects obtained when a CMOS inverter cross-coupling circuit 160 is used in a multistage buffering circuit 100 according to the first embodiment are explained hereunder. A multistage buffering circuit 300 is shown in FIG. 3 as a modified example of the present embodiment. Further, the effects of using the CMOS inverter cross-coupling circuit 160 are also explained while the multistage buffering circuit 300 is compared with the multistage buffering circuit 100. The multistage buffering circuit 300 has a circuit structure wherein the CMOS inverter cross-coupling circuit 160 is replaced with capacitors C300a and C300b. Furthermore, the waveforms in the operations of the multistage buffering circuit 300 are shown in FIG. 4.

In the multistage buffering circuit 100 or 300, the deteriorations of duty ratios are compensated by: raising or lowering the potentials of the output signals PB and PT of the CMOS inverters 110a and 110b in accordance with the signals RB and RT; and dulling timewise the rising edges and the falling edges in the waveforms of PB and PT. As a circuit to dull the rising edge and the falling edge in a waveform, a low-pass filter composed of capacitors is generally used as shown in FIG. 3. Consequently, in the multistage buffering circuit 300 shown in FIG. 3, the aforementioned dull waveforms are formed by using the capacitors C300a and C300b as capacitative elements and using the function of the low-pass filter.

In the multistage buffering circuit 100, the aforementioned dull waveforms are formed with the CMOS inverter cross-coupling circuit 160 as stated above. At the node A1 for example, a potential which the CMOS inverter cross-coupling circuit 160 retains and an output from the inverter 110a cause bus fight up to the threshold voltages of the inverters 161a and 161b and thereby the waveform of PB is dulled. Once the threshold voltages of the inverters 161a and 161b are exceeded however, the bus fight disappears and the waveform of PB rises or falls sharply. The characteristic is not obtained when a waveform is dulled with a low-pass filter using capacitors. The same phenomenon is seen also at the node A2.

Consequently, when the waveforms of the differential signals PT and PB in FIG. 4 are compared with the waveforms of the differential signals PT and PB in FIG. 2, the amplitudes of the waveforms of the differential signals PT and PB in FIG. 2 are larger than those of the waveforms of the differential signals PT and PB in FIG. 4 and the threshold voltages of the next-stage CMOS inverters 130a and 130b, for example the inclinations of the waveforms in the vicinity of VDD/2, are steep.

From the above results, the jitters of a waveform are less, operations are more stable, and the compensation range of the deterioration of a duty ratio can be widened in the case of the multistage buffering circuit 100 than in the case of the multistage buffering circuit 300. Accordingly, it is understood that the circuit structure of the multistage buffering circuit 100 is superior.

In the multistage buffering circuit 300 in contrast, although the stability of circuit operations and the effect of compensating the deterioration of a duty ratio are inferior to the multistage buffering circuit 100, only the installation of capacitors is required and such a complicated circuit structure as to cross-couple CMOS inverters is not used. As a result, the multistage buffering circuit 300 has the advantage that the structure thereof can be simplified.

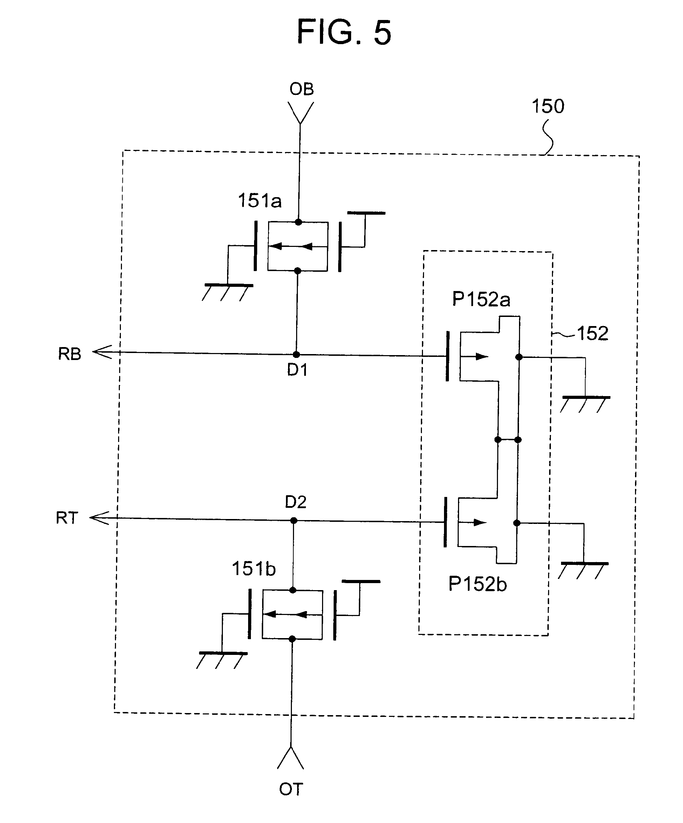

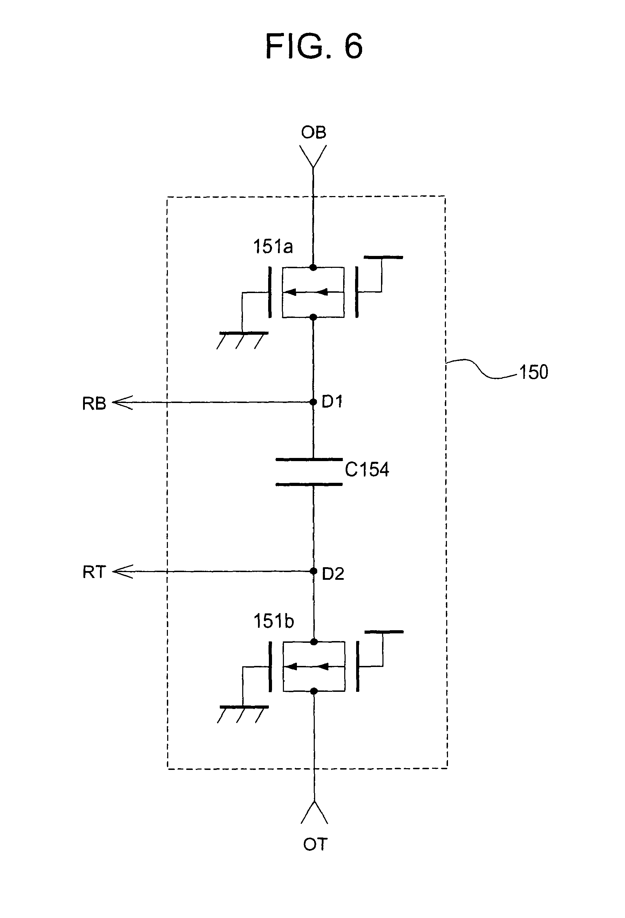

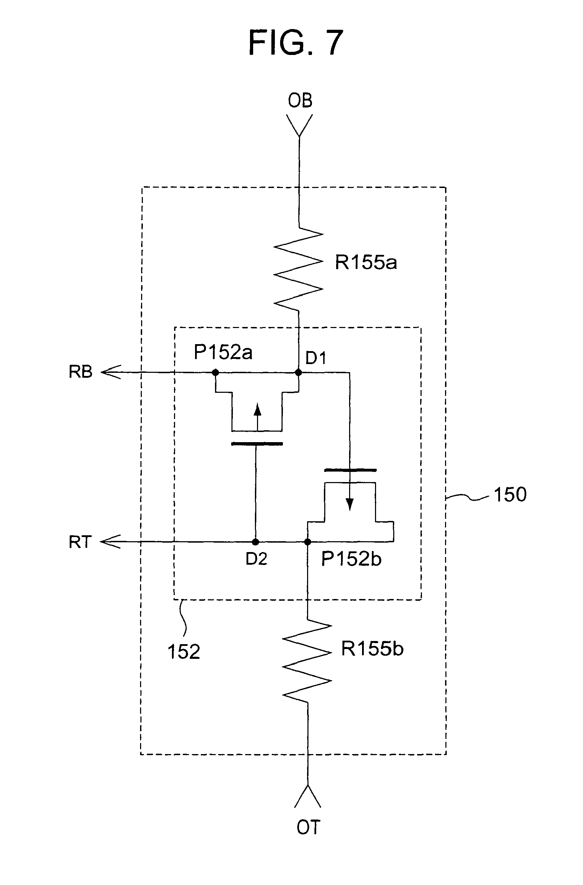

Other configuration examples of the low-pass filter 150 are hereunder shown in FIGS. 5, 6, and 7. As shown in FIG. 5, the low-pass filter 150 may be configured so as to connect the sources and drains of PMOS transistors P152a and P152b constituting a gate capacitor section 152 in an RC low-pass filter to ground terminals. Otherwise as shown in FIG. 6, a capacitative element C154 may be used instead of the gate capacitor section 152 composed of PMOS transistors. Yet otherwise as shown in FIG. 7, resistive elements R155a and P155b may be used instead of the transfer gates 151a and 151b. Further, the PMOS transistors constituting the gate capacitor section may be replaced with NMOS transistors. Furthermore, the above plural configurations may be used in combination; for example, resistive elements R155a and R155b are used instead of the transfer gates 151a and 151b and also a capacitative element 154 is used instead of the gate capacitor section 152.

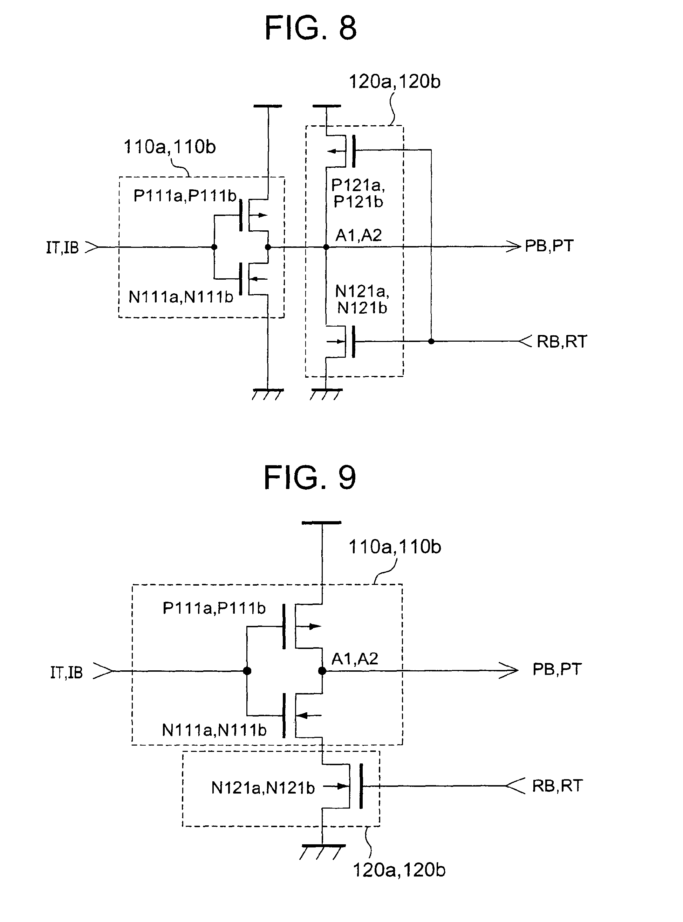

In addition, the connections between the first-stage CMOS inverters 110a and 110b and the load resistors 120a and 120b may be configured as shown in FIGS. 8 to 14.

Whereas the load resistors 120a and 120b are connected in series with the CMOS inverters 110a and 110b respectively in FIG. 1, the load resistors 120a and 120b may be connected in parallel with the CMOS inverters 110a and 110b as shown in FIG. 8. That is, the PMOS transistors P121a and P121b constituting the load resistors 120a and 120b respectively are connected between the nodes A1 and A2 and the power supply voltage terminals and the NMOS transistors N121a and N121b are connected between the nodes A1 and A2 and the ground terminals. By the circuit configuration shown in FIG. 8, operations and the effect of compensating the deteriorations of duty ratios similar to those obtained by the circuit configuration shown in FIG. 1 are obtained. In the circuit configuration shown in FIG. 8 however, the number of vertically-piled stages of transistors between a power supply voltage terminal and a ground terminal is smaller than in the case of the circuit configuration shown in FIG. 1 and hence the consumed electric current increases undesirably but it may be operated even with a low power supply voltage.

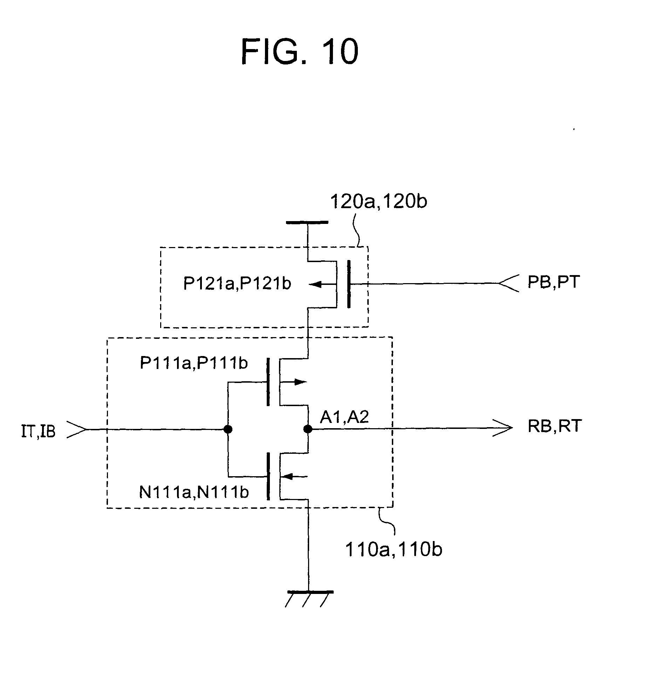

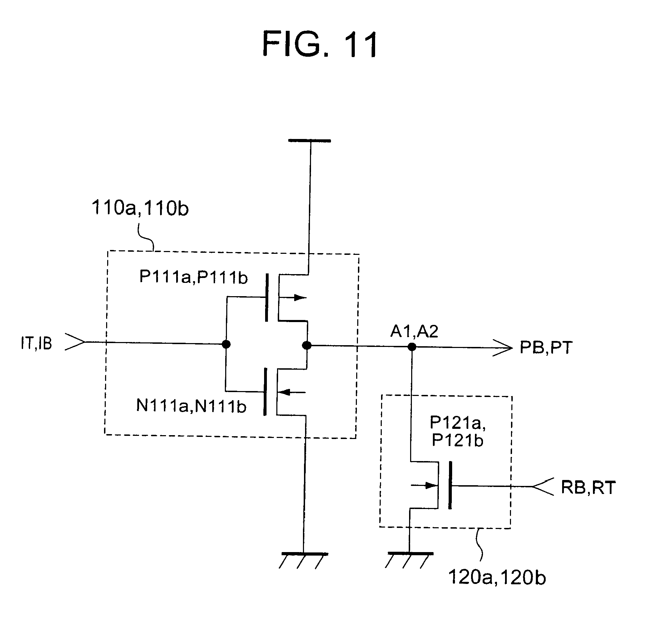

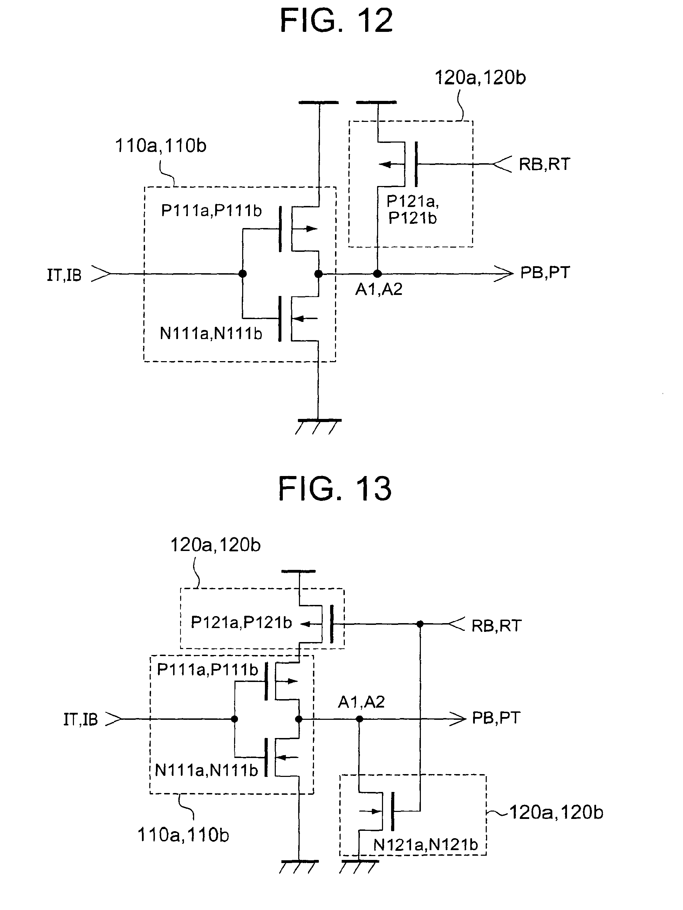

In FIG. 9, the load resistors 120a and 120b are configured only with NMOS transistors N121a and N121b respectively and connected in series between the CMOS inverters 110a and 110b and the ground terminals. In FIG. 10, the load resistors 120a and 120b are configured only with PMOS transistors P121a and P121b respectively and connected in series between the CMOS inverters 110a and 110b and the power supply voltage terminals. In FIG. 11, the load resistors 120a and 120b are configured only with NMOS transistors N121a and N121b respectively and connected between the nodes A1 and A2 as the outputs of the CMOS inverters 110a and 110b and the ground terminals. In FIG. 12, the load resistors 120a and 120b are configured only with PMOS transistors P121a and P121b respectively and connected between the nodes A1 and A2 as the outputs of the CMOS inverters 110a and 110b and the power supply voltage terminals. Further, as shown in FIG. 13, a configuration formed by combining plural circuits shown in FIGS. 10 and 11 may be used.

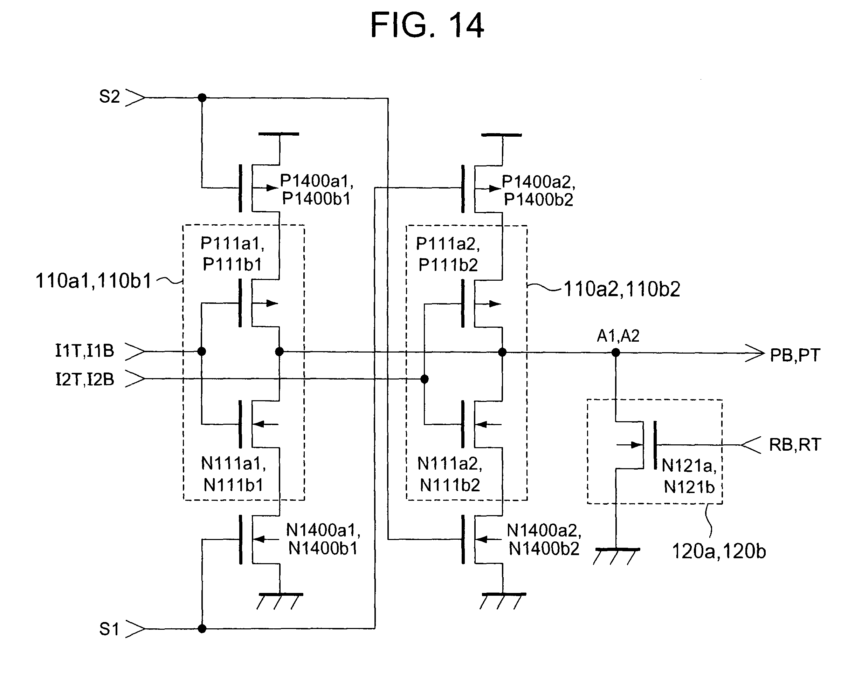

Further, the CMOS inverters 110a and 110b may not only receive a pair of input differential signals IT and IB but also receive plural pairs of differential signals. For example, as shown in FIG. 14, the circuit structure may be configured so that input differential signals I1T and I1B may be input into CMOS inverters 110a1 and 110b1 respectively and input differential signals I2T and I2B may be input into CMOS inverters 110a2 and 110b2 respectively. Then the circuit structure may be configured so that the circuit may be controlled so as to select either of the two input differential signals by turning on or off the switches of transistors P1400a1, P1400b1, P1400a2, P1400b2, N1400a1, N1400b1, N1400a2, and N1400b2 with control signals S1 and S2.

Here, the present invention is not limited to the above embodiments and may be arbitrarily modified within the range not deviating from the tenor of the present invention. for example, not only the three-stage structure formed by connecting the CMOS inverters 110a, 110b, 130a, 130b, 140a, and 140b as shown in FIG. 1 but also a single-stage structure composed of only the CMOS inverters 110a and 110b may be adopted. Otherwise, a multistage structure wherein CMOS inverters are formed in an odd number, not less than three, of stages may be adopted. by adopting such a multistage structure, it is possible to cope with the case where the amplitudes of input differential clock signals are smaller or the case where a larger output load is driven. Furthermore, the circuit may be configured so that the conductivity type of transistors may be inversed.

## Claims

1. A semiconductor circuit comprising:
a differential input section to receive input differential signals;
differential signal output terminals to output output differential signals in accordance with the voltages input into said differential input section;
a low-pass filter to extract the DC components of signals output from said differential signal output terminals; and
a load resistor section connected to said differential input section, wherein resistance values are determined on the basis of the DC components of the signals extracted with said low-pass filter.

2. The semiconductor circuit according to claim 1, wherein cross-coupled CMOS inverters are connected to said differential signal output terminals.

3. The semiconductor circuit according to claim 1 or claim 2,
wherein buffers are connected in plural stages between said differential signal output terminals and said low-pass filter.

4. The semiconductor circuit according to any one of claims 1 to 3, wherein said load resistor section is connected in series with said differential input section.

5. The semiconductor circuit according to any one of claims 1 to 3, wherein said load resistor section is connected in parallel with said differential input section.

6. The semiconductor circuit according to any one of claims 1 to 5, wherein said differential input section includes CMOS inverters.

7. The semiconductor circuit according to any one of claims 1 to 5,
wherein said differential input section has first transistors and second transistors; and
wherein said differential signal output terminals are placed between said first transistors and said second transistors, respectively.

8. The semiconductor circuit according to claim 7,
wherein said load resistor section includes third transistors and fourth transistors;
wherein said third transistors are connected between ground terminals and said first transistors, respectively; and
wherein said fourth transistors are connected between power supply voltage terminals and said second transistors, respectively.

9. The semiconductor circuit according to claim 7,
wherein said load resistor section includes third transistors; and wherein said third transistors are connected between ground terminals and said first transistors, respectively.

10. The semiconductor circuit according to claim 7,
wherein said load resistor section includes fourth transistors; and
wherein said fourth transistors are connected between power supply voltage terminals and said second transistors, respectively.

11. The semiconductor circuit according to claim 7,
wherein said load resistor section includes third transistors and fourth transistors;
wherein said fourth transistors are connected between power supply voltage terminals and said differential signal output terminals, respectively; and
wherein said third transistors are connected between ground terminals and said differential signal output terminals, respectively.

12. The semiconductor circuit according to claim 7,
wherein said load resistor section includes third transistors; and
wherein said third transistors are connected between ground terminals and said differential signal output terminals, respectively.

13. The semiconductor circuit according to claim 7,
wherein said load resistor section includes fourth transistors; and
wherein said fourth transistors are connected between power supply voltage terminals and said differential signal output terminals, respectively.

14. The semiconductor circuit according to any one of claims 1 to 13, wherein said low-pass filter has a resistor section and a capacitor section.

15. The semiconductor circuit according to claim 14, wherein said resistor section includes transfer gates.

16. The semiconductor circuit according to claim 14, wherein said resistor section includes resistive elements.

17. The semiconductor circuit according to any one of claims 14 to 16, wherein said capacitor section includes the gate capacitors of transistors.

18. The semiconductor circuit according to claim 14,
wherein said resistor section includes a first transfer gate and a second transfer gate;
wherein said capacitor section includes the gate capacitor of a fifth transistor and the gate capacitor of a sixth transistor;
wherein one of the differential signals output from said differential signal output terminals is input into one of the terminals of said first transfer gate and the other terminal is connected to a first node;
wherein the drain and the source of said fifth transistor are connected to said first node and the gate thereof is connected to a second node;
wherein the other of the differential signals output from said differential signal output terminals is input into one of the terminals of said second transfer gate and the other terminal is connected to the second node; and
wherein the drain and the source of said sixth transistor are connected to said second node and the gate thereof is connected to the first node.

19. The semiconductor circuit according to claim 14,
wherein said resistor section includes a first transfer gate and a second transfer gate;
wherein said capacitor section includes the gate capacitor of a fifth transistor and the gate capacitor of a sixth transistor;
wherein one of the differential signals output from said differential signal output terminals is input into one of the terminals of said first transfer gate and the other terminal is connected to a first node;
wherein the drain and the source of said fifth transistor are connected to a ground terminal and the gate thereof is connected to the first node;
wherein the other of the differential signals output from said differential signal output terminals is input into one of the terminals of said second transfer gate and the other terminal is connected to a second node; and
wherein the drain and the source of said sixth transistor are connected to the ground terminal and the gate thereof is connected to the second node.

20. The semiconductor circuit according to any one of claim 1 and claims 3 to 19, wherein capacitors are connected to said differential signal output terminals.
